# FASCICULE DE BREVET EUROPEEN

(11) **EP 3 635 423 B1**
(45) Date de publication et mention de la délivrance du brevet: **12.04.2023**
(21) Numéro de dépôt: 18735658.9
(22) Date de dépôt: 01.06.2018
(51) Int. Cl.: G01R 31/42, G01R 31/34, H02P 29/024, H02H 7/08, H02H 7/122

(54) **PROCÉDÉ DE TESTABILITÉ D'UNE CHAÎNE ÉLECTRONIQUE DE PUISSANCE ASSOCIÉ À UN MOTEUR ÉLECTRIQUE**
PRÜFVERFAHREN FÜR EINE ELEKTRONISCHE ANTRIEBSKETTE IN VERBINDUNG MIT EINEM ELEKTROMOTOR
TESTING METHOD FOR AN ELECTRONIC POWER CHAIN ASSOCIATED WITH AN ELECTRIC MOTOR

(30) Priorité: 06.06.2017 FR 1755005
(43) Date de publication de la demande: 15.04.2020
(73) Titulaire: Safran Nacelles, 76700 Gonfreville l'Orcher (FR)
(72) Inventeur: BENDJEDIA, Moussa, 76700 Gonfreville L'Orcher (FR); TEHRANI, Kambiz, 76700 Gonfreville L'Orcher (FR); HOBLOS, Ghaleb, 76700 Gonfreville L'Orcher (FR); NOURRISSON, Alain, 76700 Gonfreville L'Orcher (FR); CORBIN, Julien, 76700 Gonfreville L'Orcher (FR); MAALIOUNE, Hakim, 76700 Gonfreville L'Orcher (FR)
(74) Mandataire: Germain Maureau
(86) Numéro de dépôt international: PCT/FR2018/051279
(87) Numéro de publication internationale: WO 2018/224760

(56) Documents cités:
- US-A- 5 363 039
- US-A1- 2012 217 920
- US-A1- 2014 152 224
- US-A1- 2014 347 067

## Description

La présente invention concerne un procédé de testabilité en vol d'une chaîne électronique de puissance d'un composant d'aéronef.

Un avion est mû par plusieurs turboréacteurs logés chacun dans une nacelle abritant également un ensemble de dispositifs d'actionnement annexes lié à son fonctionnement et assurant diverses fonctions lorsque le turboréacteur est en fonctionnement ou à l'arrêt. Ces dispositifs d'actionnement annexes peuvent être par exemple un système mécanique d'inversion de poussée ou un système de tuyère à section variable.

Le rôle d'un inverseur de poussée est, lors de l'atterrissage d'un avion, d'améliorer la capacité de freinage de celui-ci en redirigeant vers l'avant au moins une partie de la poussée générée par le turboréacteur. Dans cette phase, l'inverseur permet de renvoyer vers l'avant de la nacelle tout ou partie des flux de gaz éjectés par le turboréacteur, générant de ce fait une contre-poussée qui vient s'ajouter au freinage des roues de l'avion.

Les moyens mis en oeuvre pour réaliser cette réorientation du flux varient suivant le type d'inverseur. Cependant, dans tous les cas, la structure d'un inverseur comprend des capots mobiles déplaçables entre, d'une part, une position déployée dans laquelle ils ouvrent dans la nacelle un passage ou une section destiné(e) au flux dévié, et d'autre part, une position d'escamotage dans laquelle ils ferment ce passage. Ces capots mobiles peuvent en outre remplir une fonction de déviation ou simplement d'activation d'autres moyens de déviation.

Dans les inverseurs à grilles, par exemple, les capots mobiles coulissent le long de rails de manière à ce qu'en reculant lors de la phase d'ouverture, ils découvrent des grilles d'aubes de déviation disposées dans l'épaisseur de la nacelle. Un système de bielles relie ce capot mobile à des portes de blocage qui se déploient à l'intérieur du canal d'éjection et bloquent la sortie en flux direct.

Dans les inverseurs à portes, chaque capot mobile pivote de manière à venir bloquer le flux direct et le dévier et est donc actif dans cette réorientation.

Par ailleurs, un aéronef comprend de manière connue deux réseaux électriques : un réseau électrique alternatif triphasé délivrant une tension alternative dite « haute tension », par exemple de 115 Volts (115V) ou 230 Volts (230V), et un réseau électrique continu dit « basse tension » délivrant par exemple une tension continue de 28 Volts (28V).

Divers composants de l'avion fonctionnent grâce au réseau électrique alternatif triphasé. Ces composants comprennent à cet effet un moteur électrique triphasé alimenté à travers un convertisseur de puissance par le réseau alternatif triphasé de l'avion. A titre d'exemple, les composants qui sont alimentés par le réseau électrique triphasé de l'avion sont les actionneurs électriques de capot d'inverseur de poussée d'une nacelle de turboréacteur, les actionneurs électriques de verrous du capot d'inverseur destinés à empêcher l'ouverture du capot d'inverseur lorsque l'avion est en vol, les actionneurs électriques de panneaux mobiles de tuyère secondaire à section variable d'une nacelle, le système électrique de déploiement du train d'atterrissage, etc. La chaîne électronique de puissance généralement mise en oeuvre pour alimenter un moteur électrique triphasé d'un composant de l'avion est la suivante : le réseau alternatif 115V (ou 230V) de l'avion alimente un convertisseur de type redresseur qui délivre une tension continue ; suivi d'un étage de filtrage désigné généralement « bus continu » ou encore « bus DC» ; cette tension est ensuite découpée via un convertisseur type onduleur afin de générer un signal triphasé alimentant le moteur électrique du composant à actionner. Ces différents étages constituant la chaîne électronique sont eux-mêmes commandés par une électronique de commande pouvant être intégrée ou non dans le même boîtier que l'électronique de puissance. De façon connue, l'électronique peut aussi incorporer une fonction « BITE» (pour « Built In Test Equipment ») surveillant le système et servant à détecter certaines pannes de l'électronique de commande et de puissance.

Afin de limiter les risques d'actionnement intempestif en vol des composants de l'avion alimentés par le réseau alternatif 115V de l'avion, ce réseau n'est rendu disponible par l'avionneur que lorsque l'avion touche le sol. En effet, l'actionnement intempestif de certains composants de l'avion en vol, comme par exemple celui du capot mobile d'inverseur de poussée, pourrait s'avérer catastrophique. La « non-disponibilité » permanente, en vol, de ce réseau alternatif triphasé de l'avion permet de constituer une des lignes de défense imposées par les exigences réglementaires de certification.

Dans le cas d'un actionneur électrique d'inverseur de poussée de nacelle, le réseau alternatif 115V de l'avion qui alimente le moteur électrique triphasé n'est disponible que lorsque l'avion touche le sol, grâce à un système appelé « Weight On Wheel » en terminologie anglo-saxonne, permettant d'autoriser la délivrance d'une tension alternative de 115V aux chaînes électronique de puissances pilotant les moteurs triphasés du dispositif d'actionnement de l'inverseur de poussée dès que le dit système a détecté le contact de l'avion avec le sol. Lorsque l'avion a atterri et lorsque le pilote commande le déploiement du système d'inversion de poussée, le dispositif d'actionnement de l'inverseur de poussée est alimenté par le réseau électrique alternatif 115V ; L'électronique de commande et de puissance de ce dispositif d'actionnement de l'inverseur de poussée peut alors délivrer le courant électrique nécessaire au pilotage des moteurs électriques, lesquels moteurs entraînant une activation des actionneurs assurant le déploiement ou l'escamotage du ou des capot(s) d'inverseur.

En cas de dysfonctionnement de la chaîne électronique de puissance d'un des actionneurs du dispositif d'inversion de poussée, le pilote ne décèle cette panne qu'au moment où il commande le déploiement de l'inverseur, c'est-à-dire au sol, lorsque l'avion a atterri. Il en va de même pour tous les autres composants de l'avion alimentés par le réseau alternatif triphasé de l'avion et qui ne peuvent être actionnés que lorsque l'avion a touché le sol.

Cette situation est inconfortable pour le pilote et pour la sécurité de l'atterrissage en particulier dans des configurations difficiles, car il ne peut pas anticiper un dysfonctionnement des composants précités avant que l'avion n'ait atterri.

Des documents pertinents de l'état de la technique sont US 2014/347067 A1, US 2012/217920 A1 et US 2014/152224 A1.

La présente invention a pour but de résoudre tout ou partie des inconvénients mentionnés ci-dessus sous la forme d'un procédé de testabilité comme défini dans la revendication indépendante 1.

Grâce à ces dispositions, il est possible de générer des stimuli dans la chaîne électronique de puissance pilotant le moteur, lesquels stimuli permettent de tester en vol la disponibilité de certains composants de cette électronique de puissance, sans pour autant actionner le moteur électrique. Le pilote peut par conséquent, en vol, vérifier le bon fonctionnement de la chaîne électrique en détectant notamment des défauts du type court-circuit ou circuit ouvert présents dans la chaîne électronique de puissance, formant en particulier un convertisseur, ou dans au moins une partie de circuit du moteur, formant en particulier des enroulements statoriques. En testant la disponibilité de la chaîne électronique de puissance peu de temps avant l'atterrissage, le pilote peut alors prendre une décision dans le cas où le composant testé de l'avion n'est pas fonctionnel, comme par exemple celle d'atterrir sur une autre piste d'atterrissage qui serait davantage adaptée à la présence de la défaillance sur le composant de l'avion.

Selon un mode de réalisation, l'étape de transmission d'un signal de test comprend l'application à ladite chaîne électronique de puissance du moteur électrique (300) d'une alimentation basse tension (130) issue d'un réseau électrique de l'aéronef.

Selon l'invention, la chaîne électronique de puissance est isolée de l'alimentation de puissance nominale de l'aéronef pendant la séquence de testabilité du procédé.

Selon un mode de réalisation, l'au moins un signal de mesure représentatif de l'état de fonctionnement de la chaîne électronique de puissance est collecté en provenance d'au moins un capteur appartenant à la chaîne électronique de puissance.

Selon un mode de réalisation non couvert par le texte des revendications, l'au moins un capteur peut comprendre un capteur de mesure de courant d'une phase moteur ou capteur dans les bras de commutation du convertisseur de puissance, un capteur de courant et/ou de tension d'un bus continu DC de ladite chaîne électronique de puissance.

Selon un mode de réalisation non couvert par le texte des revendications, l'au moins un capteur peut comprendre un capteur de mesure de courant d'une phase moteur ou capteur dans les bras de commutation du convertisseur de puissance, un capteur de courant et/ou de tension d'un bus continu de ladite chaîne électronique de puissance.

Selon un mode de réalisation, l'étape de transmission d'un signal de test comprend l'injection d'une séquence d'impulsions électriques sur le bus continu.

Selon un mode de réalisation, l'étape de transmission d'un signal de test comprend l'injection d'une rampe de tension sur le bus continu.

Selon un mode de réalisation, l'état de fonctionnement correspond à un état apte à fonctionner ou à un état de défaut de fonctionnement. L'état de défaut de fonctionnement est obtenu si au moins un défaut est détecté par le procédé de testabilité. L'état de bon fonctionnement est obtenu si aucun défaut n'est détecté par le procédé de testabilité.

Selon un mode de réalisation, l'au moins un critère de test définit un ensemble d'autorisations définissant des valeurs de l'au moins signal de mesure correspondant à un état apte à fonctionner et un ensemble d'interdictions définissant des valeurs de l'au moins signal de mesure correspondant à un état de défaut de fonctionnement.

Selon un mode de réalisation, le signal de test comprend une composante courant et/ou une composante tension, et l'ensemble d'autorisation comprend au moins un ensemble d'autorisation en courant et/ou au moins un ensemble d'autorisation en tension.

Un mode de réalisation non couvert par le texte des revendications concerne un dispositif de testabilité pour tester en vol un état de fonctionnement d'une chaîne électronique de puissance comprenant au moins un convertisseur de puissance destiné à piloter un moteur électrique ; le moteur électrique actionnant au moins un composant intégré à une nacelle de turboréacteur d'aéronef ; le dispositif de testabilité met en oeuvre le procédé de testabilité selon l'invention.

Un autre mode de réalisation non couvert par le texte des revendications concerne une nacelle pour turboréacteur d'aéronef comprenant un dispositif d'inversion de poussée, ledit dispositif d'inversion de poussée comprenant :
- un capot, mobile entre une position déployée dans laquelle ledit capot ouvre un passage dans ladite nacelle et une position d'escamotage dans laquelle ledit capot ferme ledit passage ;
- au moins un actionneur configuré pour mouvoir ledit capot alternativement entre lesdites positions d'escamotage et déployée, ledit actionneur étant commandé par le moteur électrique piloté par le convertisseur de puissance configuré pour être alimenté par un réseau électrique alternatif triphasé ;
ladite nacelle étant caractérisée en ce qu'elle comprend en outre un dispositif de testabilité selon le mode de réalisation non couvert.

Un mode de réalisation non couvert par le texte des revendications concerne enfin un aéronef comprenant un composant commandé par un moteur électrique piloté par au moins un convertisseur de puissance configuré pour être alimenté par un réseau électrique alternatif triphasé, caractérisé en ce qu'il comprend un dispositif de testabilité selon le mode de réalisation non couvert.

D'autres caractéristiques et avantages de l'invention apparaîtront mieux à la lecture de la description qui suit d'un mode de réalisation de l'invention donné à titre d'exemple non limitatif.

L'invention sera mieux comprise à l'aide de la description détaillée qui est exposée ci-dessous en regard du dessin, dans lesquels :
- la figure 1 représente un exemple de chaîne électronique de puissance 100 dans lequel le procédé selon l'invention est mis en oeuvre ; un convertisseur de puissance type onduleur est représenté dans cette chaîne électronique de puissance.
- les figures 2 à 4 montre une étape de transmission de signal de test dans les différentes phases du moteur lorsque le procédé selon l'invention est mis en oeuvre ;
- la figure 5 illustre un exemple de composantes en courant (141 et 142) selon un mode de réalisation ;
- la figure 6 expose un exemple de court-circuit dans un bras de commutation du convertisseur de puissance ;
- la figure 7 présente des exemples de court-circuits au niveau des phases du moteur électrique ;
- la figure 8 représente une étape de testabilité d'une défaillance en court-circuit.
- la figure 9 illustre un exemple de rampe de tension ;
- la figure 10 montre un exemple d'ordinogramme du procédé de testabilité selon un mode de réalisation ; et
- la figure 11 expose le dispositif de testabilité compris dans un circuit de commande intégré dans un boîtier électronique qui comprend la chaîne électrique de puissance 100 et étant reliée à la masse avion.

Dans la description détaillée qui va suivre des figures définies ci-dessus, les mêmes éléments ou les éléments remplissant des fonctions identiques pourront conserver les mêmes références de manière à simplifier la compréhension de l'invention.

Le procédé de testabilité 500 de la présente demande s'applique aux convertisseurs de puissance et aux machines électriques et est mise en oeuvre par un dispositif de testabilité. A l'arrêt, des signaux de test 140 sont injectées à travers des bras de commutation et les signaux de mesures correspondants sont comparés avec des valeurs seuils préétablies 160, en d'autres termes une valeur seuil 160 peut être une valeur minimum de courant ou tension ou une valeur maximum de courant ou tension, de sorte à indiquer l'état de fonctionnement 540 du système. Le procédé de testabilité 500 utilise des capteurs de mesure des courants des phases moteurs et les capteurs de courant et tension du bus de courant continu 120 qui sont déjà installés dans le système et ne nécessite pas de capteur spécifique. Le procédé de testabilité 500 fonctionne également si on utilise des capteurs de courant dans les bras de commutation du convertisseur plutôt que dans les phases moteurs. De plus, le procédé ne requière pas une grande puissance de calcul.

Le procédé de testabilité 500 détecte les défauts de circuit ouvert ou court-circuit des différents composants de la chaîne électronique testée. Si un ou plusieurs composants de cette chaîne sont en défaut lors de la séquence de test, réalisé en vol avant l'atterrissage, le procédé de testabilité 500 indique un état de défaut de fonctionnement 595 montrant que le système n'est pas disponible et donc non opérable lors d'une prochaine utilisation.

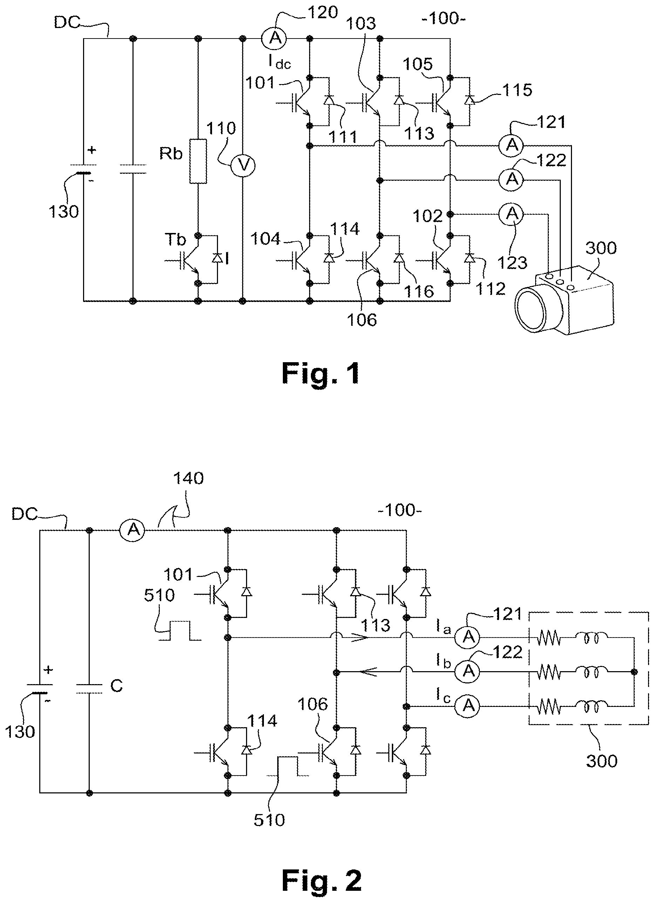

Sur la figure 1 est représenté une chaîne électronique de puissance d'un système électrique motorisé d'un aéronef comprenant un moteur électrique 300 configuré pour être piloté par un convertisseur de puissance 100 à partir d'un un bus continu DC, ce dernier pouvant par exemple provenir d'un redressement par un convertisseur AC/DC d'une tension alternative triphasé issue d'un réseau électrique de l'aéronef. Le procédé de testabilité 500 est utilisé pour tester le bon fonctionnement de cette chaine électronique de puissance.

Ce moteur électrique 300 se trouve dans une nacelle pour turboréacteur d'aéronef pouvant comprendre un dispositif d'inversion de poussée composé d'un capot, mobile entre une position déployée dans laquelle le capot ouvre un passage dans la nacelle et une position d'escamotage dans laquelle le capot ferme le passage et un actionneur configuré pour mouvoir le capot alternativement entre les positions d'escamotage et déployée. L'actionneur est commandé par le moteur électrique 300 piloté par le convertisseur de puissance configuré pour être alimenté par un réseau électrique alternatif triphasé.

Le dispositif de testabilité 50 est configuré pour tester en vol un état de fonctionnement 540 d'une chaîne électronique de puissance 100 comprenant au moins un convertisseur de puissance destiné à piloter le moteur électrique 300. Ce moteur électrique 300 actionne un composant intégré à la nacelle de turboréacteur d'aéronef.

Le procédé de testabilité 500 est défini comme une fonction de type BITE (en anglais : Built In Test Equipment soit équipement de test In Situ) qui permet de connaître l'état de fonctionnement 540 du système. Ce procédé de testabilité 500 peut être déclenché par une commande provenant d'un quelconque calculateur de l'aéronef.

En se référant à la figure 1, un schéma simplifié d'onduleur à source de tension alimentant une première phase 121, une deuxième phase 122 et une troisième phase 123 de la machine synchrone à aimant permanent 300, c'est-à-dire le moteur électrique 300, est illustré. Le convertisseur triphasé, de la chaîne électronique de puissance 100, comprend classiquement un ensemble de bras de commutation composés de six transistors bipolaire à grille isolée 101, 102, 103, 104, 105, 106 avec des diodes anti-parallèles 111, 112, 113, 114, 115, 116. Chaque bras de commutation comprend 2 transistors bipolaire à grille isolée et des diodes anti-parallèles.

Le procédé de testabilité 500 proposé utilise les capteurs de courant de la première phase 121, de la deuxième phase 122 et de la troisième phase 123 de la machine électrique et le capteur du bus de courant continu 120. Ces capteurs sont déjà présents car utilisés par le système pour le pilotage nominal du moteur électrique et il n'est donc pas nécessaire d'en rajouter. C'est également un des avantages du procédé de testabilité 500 de la présente demande.

Le procédé de testabilité 500 utilise les différents bras de commutation de l'onduleur à source de tension, en appliquant un signal de test 140 au niveau du bus continu. Ce signal de test 140 peut se présenter sous la forme d'un échelon de tension ou une rampe de tension de faible énergie, c'est-à-dire une rampe de tension dont l'énergie est inférieure à 100 mJ, d'une durée prédéterminée, de sorte à laisser immobile le moteur électrique 300 lors des étapes de procédé de testabilité 500 décrites ci-après.

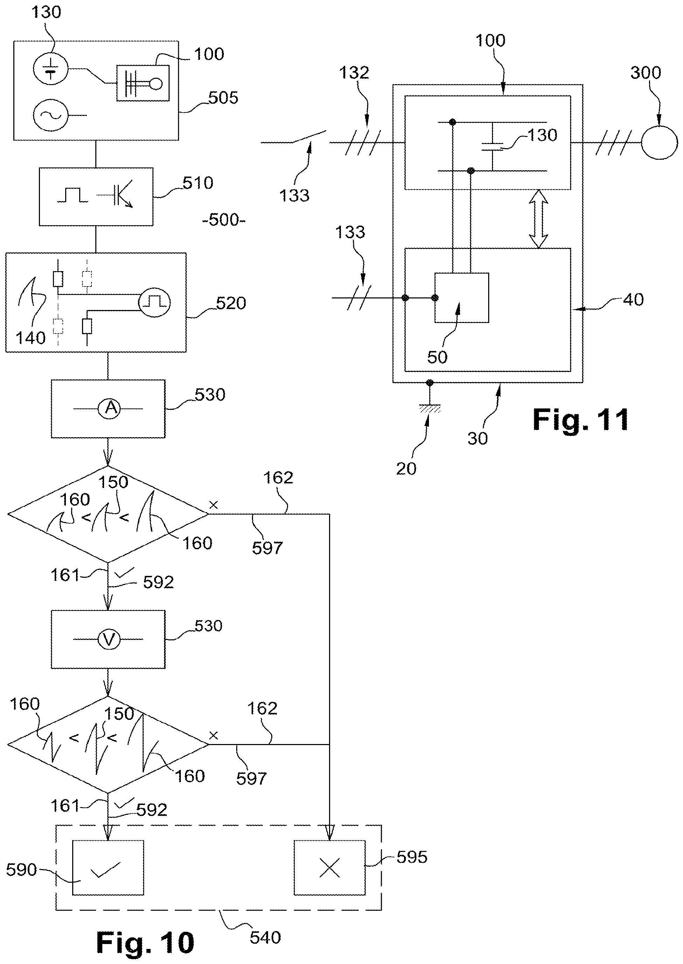

Selon une possibilité décrite sur la figure 11, le dispositif de testabilité 50 est compris dans un circuit de commande 40 intégré dans un boîtier électronique 30 qui comprend également la chaîne électrique de puissance 100 et peut être reliée à la masse avion 20.

Le dispositif de testabilité 50 met en oeuvre le procédé de testabilité 500 et comprend les composants électriques nécessaires à son bon fonctionnement. Ce dispositif de testabilité 50 est configuré pour échantillonner avec une période d'échantillonnage au moins deux fois inférieure à la durée du signal de test 140. Le dispositif de testabilité permet de générer des impulsions de largeur et de valeur de tension variables qui peuvent être injectés sur le positif du bus continu par rapport au neutre du réseau avion ou de la masse avion si le neutre est connecté à la masse avion et sur le négatif du bus continu par rapport au neutre du réseau avion. Ce dispositif doit pouvoir également déconnecter la connexion au neutre du réseau avion ou à la masse avion si le neutre est connecté à la masse avion.

Lors d'une étape de transmission 520 du signal de test 140, le procédé de testabilité 500 effectue une activation d'une alimentation basse tension de ladite chaîne électronique de puissance 100 du moteur électrique 300 à partir d'un réseau électrique de l'aéronef.

En effet, des stimuli sont générés dans la chaîne électronique de puissance 100 du moteur lors de l'étape de transmission 520 du signal de test 140 en appliquant une alimentation basse tension du dispositif de testabilité sur le bus DC 130 , elle-même alimentée à partir d'un réseau continu basse tension 131 de l'aéronef (typiquement le réseau 28V continu de l'aéronef) ; pendant la séquence de test, la chaîne électronique de puissance 100 est isolée 505 de l'alimentation 132 de puissance nominale de l'aéronef (typiquement le réseau 115V de l'aéronef) par un interrupteur 133 qui est ouvert en vol.

Ces stimuli, c'est-à-dire ces signaux de test 140 injectés par séquence d'impulsions ou par rampe de tension, permettent de tester en vol la disponibilité de certains composants de l'avion, sans pour autant les actionner.

Afin d'éviter toute rotation du moteur électrique 300 durant la séquence de testabilité 500, les impulsions de tension sont de courtes durées. La durée de l'impulsion est cependant au moins supérieure au double de la période d'échantillonnage des capteurs utilisés par le dispositif de testabilité 500.

Le pilote ou tout autre système de l'avion peut, par conséquent, en vol, vérifier le bon fonctionnement de la chaîne électrique et détecter les défauts du type court circuit ou circuit ouvert présents dans la chaîne électronique de puissance 100, et en particulier dans au moins une partie de circuit du moteur, comme par exemple un enroulement de phase moteur, et en particulier aussi dans au moins un transistor de puissance constituant le convertisseur de puissance.

En testant ainsi la fonctionnalité de la chaîne électronique de puissance peu de temps avant l'atterrissage, le pilote peut par exemple prendre une décision dans le cas où un composant testé de l'avion n'est pas fonctionnel, comme par exemple celle d'atterrir sur une piste d'atterrissage qui serait davantage adaptée à la présence de la défaillance sur le composant de l'avion.

Parallèlement à cette transmission de signal de test 140, le procédé de testabilité 500 actionne successivement les bras de commutation du convertisseur de puissance 100 de sorte à générer un chemin électrique passant successivement par chacune des phases du moteur électrique 300, lors d'une étape de commande d'actionnement 510, comme cela est représenté sur la figure 2.

La figure 2 représente une première impulsion de type créneau de tension 140 appliquée aux première et deuxième phases moteurs 121, 122 à travers les transistors 101, 106 à partir de l'alimentation basse tension 130 du dispositif de testabilité. La valeur de la crête de courant mesuré dans la première phase 121 et dans le bus continu 120 est échantillonnée et mémorisée. Les diodes anti-parallèles 113, 114, en anglais freewheel diode, assurent la continuité de courant dans les première et deuxième phases 121, 122 lors de l'ouverture des transistors 101 et 106 à la fin de l'impulsion de test.

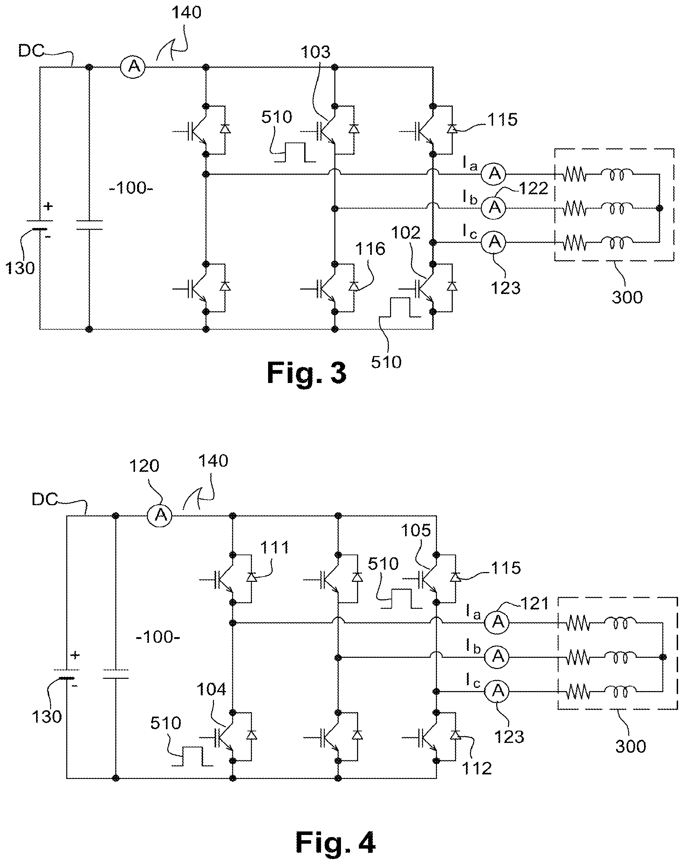

La deuxième impulsion de tension 140, similaire à la première, est appliquée aux deuxième et troisième phases moteur 122, 123 aux travers des transistors 103, 102 comme illustré sur la figure 3. La valeur des courants crêtes mesurés dans la deuxième phase et dans le bus continu 120 est échantillonnée et mémorisée. Les diodes anti-parallèles 115, 116 assurent la continuité de courant dans les enroulements de la machine électrique lors de l'ouverture des transistors 102, 103 à la fin de l'impulsion de test.

La troisième impulsion de tension 140, similaire aux première et deuxième impulsions, est appliquée aux phases moteur 121, 123 aux travers des transistors 104, 105 comme illustré par la figure 4. La valeur des courants crêtes mesurés dans la troisième phase 123 et dans le bus continu 120 est échantillonnée et mémorisée également. Les diodes anti-parallèles 111, 112 assurent la continuité de courant dans les enroulements de la machine lors de l'ouverture des transistors 104, 105 à la fin de l'impulsion de test.

Ce signal de test 140 traverse la chaîne électronique de puissance 100 et est transformé par les capteurs de cette même chaîne électronique de puissance en un signal de mesure 150 porteur d'une information sur l'état de fonctionnement 540 de la chaîne électronique de puissance 100. Ce signal de mesure 150 est collecté par le procédé de testabilité 500, en particulier, le signal de mesure 150 est collecté par au moins un capteur de mesure de courant d'une phase moteur 121, 122, 123 ou d'un bras de commutation du convertisseur, un capteur de courant et/ou de tension d'un bus de courant continu 120.

Le procédé de testabilité 500 détermine ainsi l'état de fonctionnement 540 de la chaîne de puissance 100 en fonction d'un critère de test du signal de mesure 150 collecté.

Comme cela est mentionné précédemment, la commande d'actionnement 510 et le signal de test 140 transmis sont configurés de façon à laisser immobile le moteur électrique 300 lors des étapes du procédé de testabilié 500. C'est une des caractéristiques de l'invention.

Dans le cas où la chaîne électronique de puissance 100 est en état de bon fonctionnement 590, le procédé de testabilité 500 confirme l'état de bon fonctionnement 590, en d'autres termes, l'état d'opérabilité de la machine synchrone à aimant permanent 300 est confirmé. En effet, l'étape de confirmation comprend une étape d'autorisation 592 d'utilisation du moteur triphasé ou une étape d'interdiction 597 du moteur triphasé en fonction des résultats de l'étape de vérification de l'ensemble des critères de test.

Ainsi, il est possible de déceler une panne de la chaîne électronique de puissance 100 pilotant un moteur électrique 300 sans actionner le moteur, d'une part et ainsi de prévenir l'utilisateur d'un défaut de fonctionnement d'autre part.

Cet ensemble de critères de test définit une valeur seuil 160 avec une tolérance comprise entre 2% et 5%, entre un ensemble d'autorisations 161 dans lequel ledit au moins un moteur électrique 300 est en état de fonctionner et un ensemble d'interdictions 162 dans lequel au moins un défaut de fonctionnement dans la chaîne électronique 100 entrave le bon fonctionnement dudit au moins un moteur électrique 300.

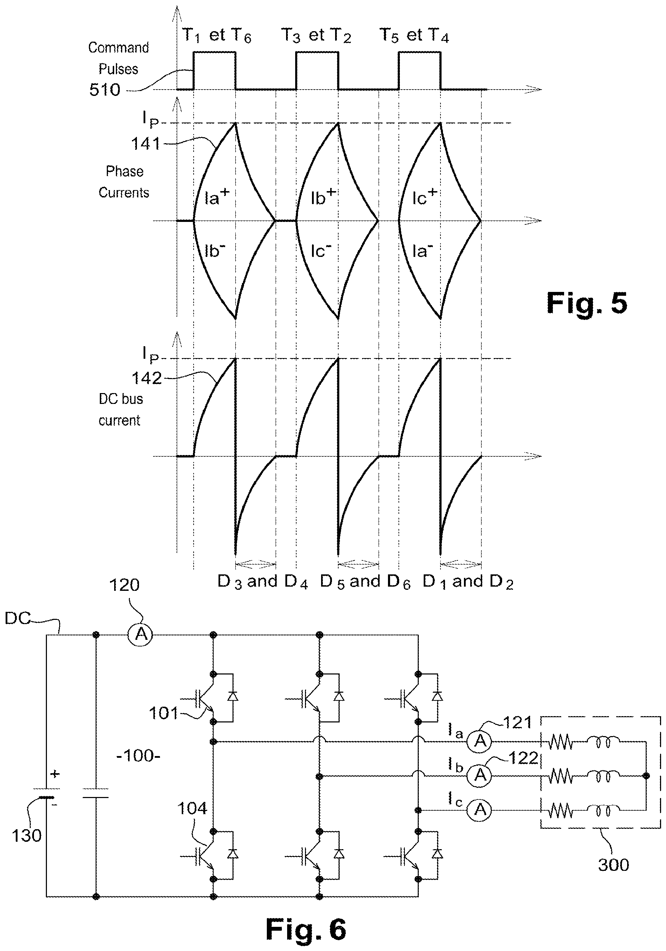

Par exemple, le signal de test 140 peut comprendre des impulsions de tension appliquée 151 sur le bus continu DC comme le montre la figure 5. Les signaux mesurés 150 peuvent être par exemple une composante courant 141 mesurée au niveau des phases de la machine électrique 121, 122, 123 ou encore une composante courant 142 mesurée au niveau du bus continu 120. Dans le cas de la composante courant 141, les mesures des courants des phases de la machine 121, 122, 123 sont comparées à un seuil minimum et un seuil maximum 160 dans le but de détecter une défaillance du système soit en circuit ouvert ou en court-circuit. Les courants crêtes peuvent faiblement varier en fonction de la position du rotor de la machine à aimant permanent et de la valeur de l'inductance des bobines statoriques, c'est pourquoi les valeurs seuils 160 du procédé de testabilité doivent être choisie en fonction des variabilités intrinsèques de la chaîne électroniques de puissance.

L'ensemble d'autorisations 161 peut comprendre également au moins un ensemble d'autorisations en courant et au moins un ensemble d'autorisation en tension. Si la machine synchrone à aimant permanent 300 présente par exemple un défaut de type court-circuit, la mesure de courant du bus continu 141 aurait une valeur importante donc supérieure à une valeur seuil préétablie. De même la mesure de tension du bus continu serait pratiquement nulle donc inférieure à une valeur seuil préétablie. Ces valeurs mesurées 150 pendant la séquence de test ne seraient pas comprises dans l'ensemble d'autorisation 161 mais dans l'ensemble d'interdiction 162.

Dans le cas d'un circuit ouvert, la mesure des courants de phase 141 serait pratiquement nulle donc inférieure à une valeur seuil préétablie et ne serait pas comprises dans l'ensemble d'autorisation 161 mais dans l'ensemble d'interdiction 162.

En général, un défaut par circuit ouvert ou court-circuit survient fréquemment dans les systèmes d'entraînement électriques et peut être détecté par un procédé de testabilité 500. A titre d'exemple, la défaillance d'un transistor en circuit ouvert peut résulter d'une rupture d'un bonding du composant de puissance due à une fatigue thermique ou un défaut de commande du transistor. La défaillance d'un transistor en court-circuit peut résulter d'une mauvaise commande en tension ou à un défaut intrinsèque au composant qui peut être causé par une surtension ou un dépassement en température.

En appliquant les impulsions de tension 140 sur les bras de commutation des grilles des transistors 101, 106, le courant crête traverse ces deux transistors 101, 106 et les deux capteurs des courants des première et deuxième phases 121, 122, comme illustré sur la figure 2

Si l'un des transistors 101, 106 est en circuit ouvert, le courant mesuré est nul et donc le procédé de testabilité 500 indique un état de défaut de fonctionnement 595. La même séquence est appliquée avec les deux autres impulsions de commandes comme représentés aux figures 3 et 4.

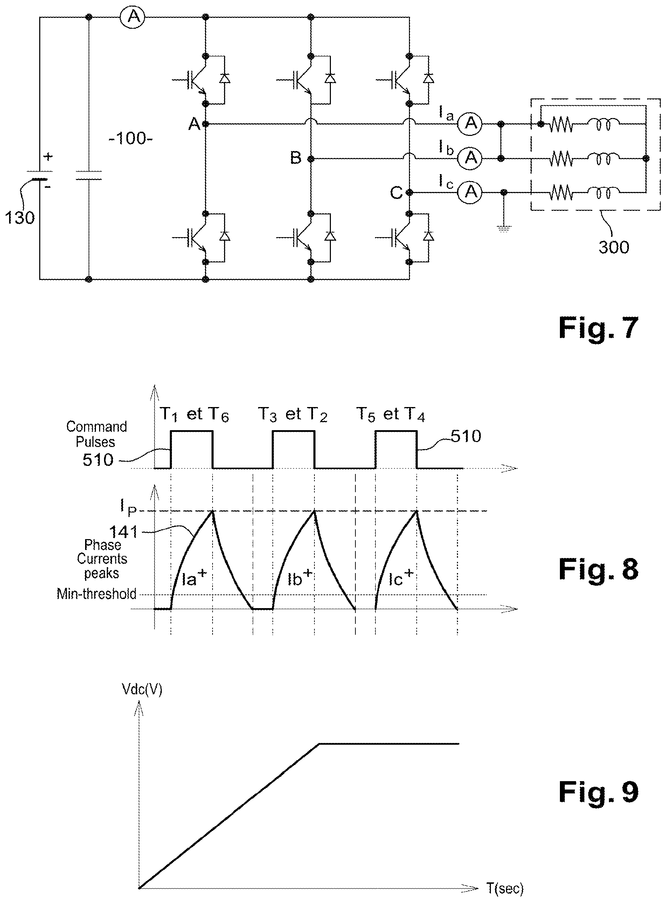

Le procédé de testabilité 500 compare la valeur crête de courant mesurée dans la première et deuxième phase avec une valeur seuil minimum 160 comme montré dans la Fig. 8. De manière à prendre en compte les imperfections des capteurs de courant, la valeur du seuil minimum 160 peut être supérieure à zéro.

Chacune de ces impulsions de test permet ainsi de détecter des défauts de circuit ouvert des transistors 101, 102, 103, 104, 105, 106 du convertisseur ou des défauts de commande d'ouverture intempestive de ces transistors ou des défauts de circuit ouvert des enroulements de phase du moteur électrique 300.

Dans le cas d'un court-circuit d'un transistor, les transistors du même bras de commutation sont passants comme montré sur la Figure 6 et l'état de défaut de fonctionnement 595 est détecté par le capteur de courant du bus continu 120 puisque le courant circuit dans le bras de commutation en court-circuit prend une valeur importante supérieure à une valeur seuil maximum 160

Chacune de ces impulsions de test permet ainsi de détecter des défauts de court-circuit des transistors 101, 102, 103, 104, 105, 106 du convertisseur ou des défauts de commande de fermeture intempestive de ces transistors ou des défauts de court-circuit ouvert des enroulements de phase du moteur électrique 300.

Les défauts de court-circuit moteur dus par exemple à des défauts d'isolation représentent une part significative des défauts qui surgissent durant la durée de vie d'un moteur électrique. L'environnement thermique, électrique et le stress mécanique peuvent causés des court-circuits entre les phases, entre une phase et la masse et/ou entre une phase et le neutre du moteur comme le représente la figure 7.

Un défaut de court-circuit dans une phase du stator génère un courant dans le bus de courant continu 120 plus important que dans le cas d'un circuit sain. Pour les défauts de court-circuit, le procédé de testabilité 500 compare le courant du bus de courant continu 120 mesuré avec une valeur maximum seuil 160 comme illustré à la figure 8.

La durée des impulsions de test 510 est choisie de manière à limiter la valeur crête des courants dans le cas de présence d'un court-circuit dans la chaîne électronique de puissance 100. Le procédé de testabilité permet également d'interrompre les impulsions de tension injectées quand un court-circuit est détecté par le dispositif.

Ce principe de testabilité s'applique aussi à toute fonction connectée au bus continu DC comme par exemple une fonction limitant la tension du bus de puissance et permettant de dissiper l'énergie réinjectée par la machine électrique dans une résistance de puissance connectée sur ce bus de puissance.

Le procédé de testabilité 500 établit ainsi un diagnostic sur l'état de fonctionnement 540 de la chaîne électronique de puissance 100 testée. Pour cela, le procédé de testabilité 500 analyse des mesures 150 après injection de stimuli de test 140 et les compare à des valeurs seuils préétablies 160 afin de constituer un ensemble d'autorisations 161 et d'interdictions 162. La sanction d'état non fonctionnel 595 est établi si au moins une panne est détectée par le procédé de testabilité c'est-à-dire si au moins une interdiction 162 est présente. A contrario, la sanction d'état fonctionnel 590 est établi si aucune interdiction 162 n'est établie c'est-à-dire si aucune panne n'est détectée pendant le test.

Le procédé de testabilité 500 permet également de tester si un court-circuit est présent dans les composants du système. Une transmission 520 d'au moins un signal de test 140 sous la forme d'une rampe de tension dans la chaîne électronique de puissance 100 comme cela est représentée sur la figure 9. Lors de cette transmission 520, les transistors 102, 104, 106 sont commandés simultanément de sorte à tester les transistors 101, 103, 105.

Ce signal de test 140 est généré par une source de courant qui charge le condensateur C du bus continu DC. Si un court-circuit est présent la tension du bus continu DC reste nulle ou proche de zéro.

Dès lors, le procédé de testabilité 500, représenté sur la figure 10, collecte 530 un signal de mesure 150 plus exactement une absence de tension puisque la tension du bus continu DC reste nulle ou proche de zéro.

Le procédé de testabilité 500 détermine 540 l'état de fonctionnement 590 de la chaîne de puissance et en l'occurrence que l'état de fonctionnement 590 de la chaîne électronique de puissance n'est pas en état de fonctionnement.

Dans le cas contraire, c'est-à-dire si la tension du bus continu DC est supérieure à une valeur seuil minimum, alors le procédé de testabilité 500 détermine 540 que l'état de fonctionnement 590 de la chaîne de puissance est en état de fonctionnement car il n'y a pas de court-circuit.

À la suite de cette étape de test en tension, l'alimentation de testabilité est stoppée et la tension du bus continu DC est déchargé et c'est au tour des transistors 101, 103, 105 de chaque bras sont commandés simultanément de sorte à tester les transistors 102, 104, 106.

De nouveau, un signal de test 140 est généré par une source de courant qui charge le condensateur C du bus continu DC et si un court-circuit est présent la tension du bus continu DC reste nulle ou proche de zéro.

Il s'ensuit que le procédé de testabilité 500 collecte 530 le signal de mesure 150 du bus continu DC et détermine 540 l'état de fonctionnement 590 de la chaîne de puissance. Comme précédemment, si le signal de mesure 150 indique que la chaîne électronique de puissance n'est pas en état de fonctionnement.

À contrario, c'est-à-dire si la tension du bus continu DC est supérieure à une valeur seuil minimum, alors le procédé de testabilité 500 détermine 540 que l'état de fonctionnement 590 de la chaîne de puissance est en état de fonctionnement car il n'y a pas de court-circuit.

## Revendications

1. Procédé de testabilité (500) pour tester en vol un état de fonctionnement (540) d'une chaîne électronique de puissance (100) comprenant au moins un convertisseur de puissance destiné à piloter un moteur électrique (300); le moteur électrique (300) actionnant au moins un composant d'aéronef; le procédé de testabilité (500) comprenant au moins les étapes suivantes :
- Commande d'actionnement (510) du convertisseur de sorte à générer un chemin électrique passant par le moteur électrique (300) ;
- Transmission (520) d'au moins un signal de test (140) dans la chaîne électronique de puissance (100) ;
- Collecte (530) d'au moins un signal de mesure (150) représentatif de l'état de fonctionnement (590) de la chaîne électronique de puissance ;
- Détermination (540) d'un état de fonctionnement (590) de la chaîne de puissance en fonction d'au moins un critère de test de l'au moins un signal de mesure (150) collecté ;
l'au moins une commande d'actionnement et l'au moins un signal de test (140) transmis étant configurés de façon à laisser immobile ledit au moins un moteur électrique (300) lors des étapes du procédé de testabilité (500),
procédé de testabilité (500), **caractérisé en ce qu'**il comprend l'étape suivante :
Génération de stimuli dans la chaîne électronique de puissance (100), ces stimuli permettent de tester en vol la disponibilité des composants de l'aéronef, sans les actionner, et que
la chaîne électronique de puissance (100) est isolée (505) de l'alimentation de puissance nominale de l'aéronef pendant la séquence de testabilité du procédé (500).

2. Procédé de testabilité (500) selon la revendication 1, dans lequel l'étape de transmission (520) d'un signal de test (140) comprend l'application à la chaîne électronique de puissance (100) du moteur électrique (300) d'une alimentation basse tension (130) issue d'un réseau électrique de l'aéronef.

3. Procédé de testabilité (500) selon l'une des revendications précédentes, dans lequel l'au moins un signal de mesure (150) représentatif de l'état de fonctionnement (590) de la chaîne électronique de puissance est collecté en provenance d'au moins un capteur appartenant à la chaîne électronique de puissance (100).

4. Procédé de testabilité (500) selon l'une des revendications précédentes, dans lequel l'étape de transmission (520) d'un signal de test (140) comprend l'injection d'une séquence d'impulsions électriques sur le bus continu.

5. Procédé de testabilité (500) selon l'une des revendications précédentes, dans lequel l'étape de transmission (520) d'un signal de test (140) comprend l'injection d'une rampe de tension sur le bus continu sur le bus continu.

6. Procédé de testabilité (500) selon l'une des revendications précédentes, dans lequel l'état de fonctionnement (540) correspond à un état apte à fonctionner (590) ou à un état de défaut de fonctionnement (595).

7. Procédé de testabilité (500) selon la revendication 5, dans lequel l'au moins un critère de test définit un ensemble d'autorisations (161) définissant des valeurs de l'au moins signal de mesure (150) correspondant à un état apte à fonctionner et un ensemble d'interdictions (162) définissant des valeurs de l'au moins signal de mesure (150) correspondant à un état de défaut de fonctionnement (595).

8. Procédé de testabilité (500) selon l'une des revendications précédentes, dans lequel le signal de test (140) comprend une composante courant (141, 142)et/ou une composante tension (110), et l'ensemble d'autorisation (161) comprend au moins un ensemble d'autorisation (161) en courant et/ou au moins un ensemble d'autorisation (161) en tension.

## Patentansprüche

1. Prüfbarkeitsverfahren (500) zur Flugerprobung eines Betriebszustands (540) einer elektronischen Leistungskette (100), mindestens einen Leistungswandler umfassend, der zum Antreiben eines Elektromotors (300) bestimmt ist; wobei der Elektromotor (300), mindestens eine Komponente des Luftfahrzeugs betätigt; wobei das Prüfbarkeitsverfahren (500) mindestens die folgenden Schritte umfasst:
- Befehl der Betätigung (510) des Wandlers, um einen elektrischen Pfad zu erzeugen, der durch den Elektromotor (300) verläuft;
- Übertragung (520) von mindestens einem Prüfsignal (140) in der elektronischen Leistungskette (100);
- Erfassung (530) mindestens eines Messsignals (150), das für den Betriebszustand (590) der elektronischen Leistungskette repräsentativ ist;
- Ermittlung (540) eines Betriebszustands (590) der Leistungskette in Abhängigkeit von mindestens einem Prüfkriterium des mindestens einen erfassten Messsignals (150);
wobei der mindestens eine Betätigungsbefehl und das mindestens eine übertragene Prüfsignal (140) so konfiguriert sind, dass der mindestens eine Elektromotor (300) während der Schritte des Prüfbarkeitsverfahrens (500) unbeweglich bleibt,
Prüfbarkeitsverfahren (500), **dadurch gekennzeichnet, dass** es den folgenden Schritt umfasst:
Erzeugung von Reizen in der elektronischen Leistungskette (100), wobei diese Reize die Flugerprobung der Verfügbarkeit von Komponenten des Luftfahrzeugs ermöglichen, ohne sie zu betätigen, und dass
die elektronische Leistungskette (100) während der Sequenz der Prüfbarkeit des Verfahrens (500) isoliert (505) ist von der Versorgung der nominalen Leistung des Luftfahrzeugs.

2. Prüfbarkeitsverfahren (500) nach Anspruch 1, wobei der Übertragungsschritt (520) eines Prüfsignals (140) das Anlegen, an die elektronische Leistungskette (100) des Elektromotors (300), einer Niederspannungsversorgung (130) umfasst, die von einem elektrischen Netz des Luftfahrzeugs hervorgegangen ist.

3. Prüfbarkeitsverfahren (500) nach einem der vorhergehenden Ansprüche, wobei mindestens ein Messsignal (150), das für den Betriebszustand (590) der elektronischen Leistungskette repräsentativ ist, von mindestens einem Sensor erfasst wird, der zur elektronischen Leistungskette (100) gehört.

4. Prüfbarkeitsverfahren (500) nach einem der vorhergehenden Ansprüche, wobei der Übertragungsschritt (520) eines Prüfsignals (140) die Injektion einer Sequenz von elektrischen Impulsen in den DC-Bus umfasst.

5. Prüfbarkeitsverfahren (500) nach einem der vorhergehenden Ansprüche, wobei der Übertragungsschritt (520) eines Prüfsignals (140) die Injektion einer Spannungsrampe in den DC-Bus umfasst.

6. Prüfbarkeitsverfahren (500) nach einem der vorhergehenden Ansprüche, wobei der Betriebszustand (540) einem betriebsfähigen Zustand (590) oder einem Betriebsfehlerzustand (595) entspricht.

7. Prüfbarkeitsverfahren (500) nach Anspruch 5, wobei das mindestens eine Prüfkriterium einen Berechtigungssatz (161) definiert, der Werte des mindestens Messsignals (150) definiert, die einem betriebsfähigen Zustand entsprechen, und einen Satz von Verboten (162), der Werte des mindestens Messsignals (150) definiert, die einem Betriebsfehlerzustand (595) entsprechen.

8. Prüfbarkeitsverfahren (500) nach einem der vorhergehenden Ansprüche, wobei das Prüfsignal (140) eine Stromkomponente (141, 142) und/oder eine Spannungskomponente (110) umfasst, und der Berechtigungssatz (161) mindestens einen Stromberechtigungssatz (161) und/oder mindestens einen Spannungsberechtigungssatz (161) umfasst.

## Claims

1. A testability method (500) for in-flight testing of an operating state (540) of an electronic power chain (100) comprising at least one power converter intended to pilot an electric motor (300); the electric motor (300) actuating at least one aircraft component; the testability method (500) comprising at least the following steps of:
- Controlling the actuation (510) of the converter so as to generate an electric path passing through the electric motor (300);
- Transmitting (520) at least one test signal (140) in the electronic power chain (100);
- Collecting (530) at least one measurement signal (150) representative of the operating state (590) of the electronic power chain;
- Determining (540) an operating state (590) of the power chain according to at least one test criterion of the at least one collected measurement signal (150);
the at least one actuation control and the at least one transmitted test signal (140) being configured so as to leave said at least one electric motor (300) immobile during the steps of the testability method (500),
the testability method (500), being **characterized in that** it comprises the following step of:
- Generating stimuli in the electronic power chain (100), these stimuli allow testing, in flight, the availability of the components of the aircraft without actuating them; and that
the electronic power chain (100) is isolated (505) from the nominal power supply of the aircraft during the testability sequence of the method (500).

2. The testability method (500) according to claim 1, wherein the test signal (140) transmission step (520) comprises the application of a low voltage supply (130) originating from an electrical network of the aircraft to the electronic power chain (100) of the electric motor (300).

3. The testability method (500) according to any of the preceding claims, wherein the at least one measurement signal (150) representative of the operating state (590) of the electronic power chain is collected from at least one sensor belonging to the electronic power chain (100).

4. The testability method (500) according to any of the preceding claims, wherein the test signal (140) transmission step (520) comprises the injection of a sequence of electric pulses on the direct current bus.

5. The testability method (500) according to any of the preceding claims, wherein the test signal (140) transmission step (520) comprises the injection of a voltage ramp on the direct current bus.

6. The testability method (500) according to any of the preceding claims, wherein the operating state (540) corresponds to an operative state (590) or to an operation defect state (595).

7. The testability method (500) according to claim 5, wherein the at least one test criterion defines a set of authorizations (161) defining values of the at least one measurement signal (150) corresponding to an operative state and a set of prohibitions (162) defining values of the at least one measurement signal (150) corresponding to an operation defect state (595).

8. The testability method (500) according to any of the preceding claims, wherein the test signal (140) comprises a current component (141, 142) and/or a voltage component (110), and the authorization set (161) comprises at least one current authorization set (161) and/or at least one voltage authorization set (161).
